# EUROPÄISCHE PATENTSCHRIFT

(11) **EP 2 619 807 B1**
(45) Veröffentlichungstag und Bekanntmachung des Hinweises auf die Patenterteilung: **21.12.2016**
(21) Anmeldenummer: 11758444.1
(22) Anmeldetag: 14.09.2011
(51) Int. Cl.: H01L 33/40, H01L 33/38

(54) **OPTOELEKTRONISCHER HALBLEITERCHIP UND VERFAHREN ZU DESSEN HERSTELLUNG**
OPTOELECTRONIC SEMICONDUCTOR CHIP, AND METHOD FOR THE FABRICATION THEREOF
PUCE À SEMI-CONDUCTEUR OPTOÉLECTRONIQUE ET SON PROCÉDÉ DE PRODUCTION

(30) Priorität: 20.09.2010 DE 102010046089
(43) Veröffentlichungstag der Anmeldung: 31.07.2013
(73) Patentinhaber: OSRAM Opto Semiconductors GmbH, 93055 Regensburg (DE)
(72) Erfinder: BEHRINGER, Martin Rudolf, 93049 Regensburg (DE); KLEMP, Christoph, 93049 Regensburg (DE); RUPPRICH, Christoph, 93142 Maxhütte-Haidhof (DE)
(74) Vertreter: Epping - Hermann - Fischer
(86) Internationale Anmeldenummer: PCT/EP2011/065950
(87) Internationale Veröffentlichungsnummer: WO 2012/038313

(56) Entgegenhaltungen:
- EP-A2- 1 806 790
- JP-A- 2008 124 375
- US-A1- 2004 135 166
- US-A1- 2008 185 609
- US-A1- 2010 032 699
- US-A1- 2010 065 867

## Beschreibung

In der Druckschrift US 2010/0032699 A1 ist eine Leuchtdiode angegeben.

Die Druckschrift US 2004/0135166 A1 betrifft eine Leuchtdiode und eine Herstellungsverfahren hierfür.

Eine Elektrode für eine Nitrid-Leuchtdiode findet sich in der Druckschrift US 2008/0185609 A1.

Die Beschreibung einer Herstellungsmethode für eine Leuchtdiode lässt sich der Druckschrift JP 2008-124375 A entnehmen.

Die Erfindung betrifft einen optoelektronischen Halbleiterchip mit einem Träger, einem Halbleiterschichtenstapel und einem Spiegel gemäß Patentanspruch 1. Weiter betrifft die Erfindung ein Verfahren zum Herstellen eines solchen optoelektronischen Halbleiterchips gemäß Patentanspruch 7.

Bei herkömmlichen optoelektronischen Halbleiterchips, wie beispielsweise Licht emittierende Dioden (LED) ändert sich die von dem Bauelement emittierte Leistung über die Lebensdauer. Beispielsweise verlieren LEDs, die Strahlung im roten Wellenlängenbereich emittieren, während der ersten zehntausend Betriebsstunden typischerweise 5 bis 10 % ihrer Helligkeit.

Als Lebensdauer wird insbesondere die Zeit definiert, in welcher die Helligkeit der emittierten Strahlung des Halbleiterchips bis auf einen definierten Bruchteil des Anfangwerts absinkt.

Die Änderung, insbesondere der Verlust der Leistung im Betrieb über die Lebensdauer des Halbleiterchips ist dem Fachmann auch als Alterungsverhalten bekannt. Alterungseffekte derartiger Halbleiterchips basieren beispielsweise auf Defekte und Störstellen im Halbleiterchip, insbesondere auf der Dichte der Defekte und deren Beweglichkeit.

Derartige Defekte können im Kristall bei Wachstum oder aufgrund Gitterfehlanpassungen zwischen Substrat und Halbleiterschichten auftreten, wobei die Defekte sich ausbreiten und wandern können. Zudem können Defekte auftreten, die von außen in die Halbleiterschichten hinein diffundieren, beispielsweise durch Verspannungen anderer Schichten und montagebedingte Effekte.

Derartige Defekte können unter anderem an Grenzflächen im Halbleiterchip auftreten, wie beispielsweise zwischen dem Träger und den Halbleiterschichten, bei einem Wechsel der Gitterstruktur zwischen den Schichten, bei unterschiedlichen Dotierungen der angrenzenden Schichten oder an abschließende Halbleiterschichten.

Derartige Defekte führen unter anderem zu einer Absorption von Licht, zu einem Leckstrom oder zu einer Änderungen beziehungsweise Verzehrung der Gitterstruktur. Diese nachteilige Wirkung der Defekte wird weiter verstärkt durch hohe Ströme im Betrieb der Halbleiterchips, einer hohen Betriebstemperatur, einer hohen Photononendichte, und ähnliches. Insbesondere wird die Wirkung verstärkt durch Effekte, die die Dichte und Beweglichkeit erhöhen. Beispielsweise reduziert sich aufgrund dieser Wirkung die Leistung über die Lebensdauer der Halbleiterchips, wodurch nachteilig Alterungseffekte über die Lebensdauer der Halbleiterchips auftreten.

Der Erfindung liegt die Aufgabe zugrunde, einen optoelektronischen Halbleiterchip zu schaffen, der eine verbesserte Leistungsstabilität über die Lebensdauer aufweist. Weiter liegt der Erfindung die Aufgabe zugrunde, ein Herstellungsverfahren eines derartigen Halbleiterchips anzugeben.

Diese Aufgabe wird unter anderem durch einen optoelektronischen Halbleiterchip mit den Merkmalen des Patentanspruchs 1 und ein Verfahren zu dessen Herstellung mit den Merkmalen des Patentanspruchs 7 gelöst. Vorteilhafte Weiterbildungen des Halbleiterchips und dessen Verfahren zur Herstellung sind Gegenstand der abhängigen Ansprüche.

Es ist ein optoelektronischer Halbleiterchip vorgesehen, der einen Halbleiterschichtenstapel und einen Spiegel aufweist. Der Halbleiterschichtenstapel weist eine aktive Schicht zur Erzeugung elektromagnetischer Strahlung auf. Der Spiegel ist an einer Unterseite des Halbleiterschichtenstapels angeordnet und weist einen ersten und einen zweiten Bereich auf. Der erste Bereich enthält Silber (Ag). Der zweite Bereich enthält Gold (Au).

Ein optoelektronischer Halbleiterchip ist ein Halbleiterchip, der die Umwandlung von elektrischer Energie in Lichtemission ermöglicht, oder umgekehrt. Beispielsweise ist der optoelektronische Halbleiterchip ein strahlungsemittierender Halbleiterchip.

Der Spiegel setzt sich somit aus zwei Bereichen zusammen, wobei sich die zwei Bereiche in ihrer Materialzusammensetzung unterscheiden. Es weist der erste Bereich überwiegend Silber auf und ist somit als sogenannter Silberspiegel ausgebildet. Der zweite Bereich weist überwiegend Gold auf und ist somit als sogenannter Goldspiegel ausgebildet.

Im Halbleiterchip ist somit ein Goldspiegel integriert, der mit einem Silberspiegel hinterlegt ist. Alternativ ist eine umgekehrte Anordnung denkbar, also ein Silberspiegel, der mit einem Goldspiegel hinterlegt ist.

Im Falle des mit dem Silberspiegel hinterlegten Goldspiegels diffundiert während des Betriebs des Halbleiterchips das Silber in den Goldspiegel und erhöht so die Reflektivität des Spiegels über die Lebensdauer. Die Reflektivität des Spiegels steigert sich somit während des Betriebs des Halbleiterchips, insbesondere findet eine Steigerung der Reflektivität über die Lebensdauer statt. Durch diesen integrierten Spiegel im Chip, der vorzugsweise zu Beginn nicht 100 % Reflektivität aufweist und dessen Reflektivität sich über die Lebensdauer steigert, können auftretende Alterungseffekte des Halbleiterchips kompensiert werden. Insbesondere kann der über die Lebensdauer des Halbleiterchips abnehmenden internen Effizienz entgegengetreten werden, sodass die von dem Halbleiterchip emittierte Leistung im Wesentlichen konstant bleibt. So kann ein leistungsstabiler Halbleiterchip über die Lebensdauer des Halbleiterchips realisiert werden.

Im Falle des mit dem Goldspiegel hinterlegten Silberspiegels führt die Diffusion des Silbers in den Goldspiegel zu dem gegenteiligen Effekt, sodass einer über die Lebensdauer des Halbleiterchips zunehmenden Leistung des Chips entgegengetreten werden kann.

Der Halbleiterschichtenstapel weist eine Befestigungsseite auf, mit der der Schichtenstapel auf dem Spiegel angeordnet ist. Weiter weist der Halbleiterschichtenstapel eine Strahlungsaustrittsseite auf, die gegenüber der Befestigungsseite angeordnet ist, und aus der die von dem Halbleiterchip emittierte Strahlung zum größten Teil austritt. Der Halbleiterchip ist beispielsweise ein oberflächenemittierender Chip.

Der Halbleiterchip weist vorzugsweise einen Träger auf, auf dem der Spiegel und der Halbleiterschichtenstapel angeordnet sind. Der Spiegel ist somit zwischen Träger und Halbleiterschichtenstapel angeordnet. Der Träger weist an der von dem Halbleiterschichtenstapel abgewandten Seite eine Montageseite auf, mit der der Träger auf beispielsweise einer Leiterplatte angeordnet sein kann. Beispielsweise ist der Träger mit Halbleiterchip ein oberflächenmontierbares Bauelement.

Die Leiterplatte weist auf der dem Halbleiterchip zugewandten Seite elektrisch leitende Leiterbahnen auf. Der Halbleiterchip ist mittels elektrischen Kontaktierungen mit den Leiterbahnen elektrisch leitend verbunden. Beispielsweise ist eine zweiseitige Kontaktierung des Halbleiterchips vorgesehen. In diesem Fall ist der Halbleiterchip mit der Montageseite des Trägers auf einer elektrischen Leiterbahn der Leiterplatte angeordnet und mit dieser elektrisch kontaktiert. Beispielsweise ist der Halbleiterchip mit der elektrischen Leiterbahn über eine Anschlussschicht, etwa eine elektrisch leitende Klebstoff oder eine Lötschicht elektrisch leitend verbunden und/oder auf dieser befestigt.

Ein Kontaktbereich auf der Strahlungsaustrittsseite des Halbleiterchips ist mit einer weiteren Leiterbahn der Leiterplatte elektrisch leitend verbunden, beispielsweise mittels eines Bonddrahtes, der von dem Kontaktbereich des Halbleiterchips zu einer Leiterbahn führt.

Die elektrischen Leiterbahnen auf der Leiterplatte sind beispielsweise mittels eines Abstandes zueinander oder einer elektrisch isolierenden Schicht voneinander elektrisch isoliert angeordnet.

Alternativ kann der Halbleiterchip lediglich von einer Seite elektrisch kontaktiert sein, beispielsweise mit seiner Befestigungsseite. Derartige einseitige elektrische Kontaktierungen eines Halbleiterchips und damit verbundene elektrische Führungen in dem Halbleiterschichtenstapel, wie beispielsweise bei Flip-Chips, sind dem Fachmann bekannt und werden daher an dieser Stelle nicht näher erläutert. Zudem kann die einseitige Kontaktierung auf der von dem Träger abgewandten Seite des Halbleiterchips erfolgen, wobei die elektrische Kontaktierung in diesem Fall mittels zweier Bonddrähte von Kontaktbereichen des Halbleiterchips zu jeweils einer Leiterbahn erfolgt.

Der Halbleiterschichtenstapel weist eine zur Erzeugung von elektromagnetischer Strahlung geeignete aktive Schicht auf. Die aktive Schicht des Halbleiterschichtenstapels weist bevorzugt einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung auf. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen.

Bevorzugt ist der Halbleiterchip eine Licht emittierende Diode (LED).

Der Halbleiterschichtenstapel, insbesondere die aktive Schicht, enthält mindestens ein III/V-Halbleitermaterial, etwa ein Material aus den Materialsystemen InₓGa_{y}Al_{1-x-y}P, InₓGa_{y}Al_{1-x-y}N oder InₓGa_{y}Al_{1-x-y}As, jeweils mit 0 ≤ x, y ≤ 1 und x + y ≤ 1. III/V-Halbleitermaterialien sind zur Strahlungserzeugung im ultravioletten (InₓGa_{y}Al_{1-x-y}N), über dem sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet.

In einer Weiterbildung sind der erste Bereich und der zweite Bereich des Spiegels vertikal übereinander angeordnet. Der Spiegel weist somit einen Schichtstapel des ersten und des zweiten Bereichs auf, die senkrecht zur lateralen Ausdehnung des Trägers angeordnet sind. Dabei kann der zweite Bereich zwischen Halbleiterschichtenstapel und erstem Bereich angeordnet sein, wobei der erste Bereich direkt an den Träger angrenzt beziehungsweise auf diesem angeordnet ist, oder umgekehrt.

In einer Weiterbildung weisen der erste Bereich und der zweite Bereich des Spiegels eine unterschiedliche Schichtdicke auf. Hierbei ist bevorzugt der erste Bereich dicker als der zweite Bereich. Zum Beispiel ist die Dicke des zweiten Bereichs um mindestens ein 1,25-Faches oder um mindestens ein 1,5-Faches oder um mindestens eine 2,0-Faches größer und bevorzugt auch um höchstens ein 5,0-Faches oder um höchstens ein 2,5-Faches größer als die Dicke des ersten Bereichs.

In einer Weiterbildung sind die Schichtdicken des ersten Bereichs und des zweiten Bereichs derart aufeinander abgestimmt, dass ein Diffusionsverhalten von Silber aus dem ersten Bereich in den zweiten Bereich im Betreib des Halbleiterchips einstellbar ist.

Über die Schichtdicken der Bereiche des Spiegels wird somit das Diffusionsverhalten von Spiegelmaterial aus dem ersten Bereich in den zweiten Bereich eingestellt. Die Dicke der Bereiche des Spiegels zueinander sind dabei so aufeinander abgestimmt, dass eine gewünschte Diffusion beziehungsweise ein gewünschtes Diffusionsverhalten im Betrieb des Halbleiterchips auftritt. Aufgrund der Diffusion von Silber aus dem ersten Bereich in den zweiten Bereich des Spiegels ändert sich die Reflektivität des Spiegels über die Lebensdauer. Dadurch kann einer Leistungsänderung des Halbleiterchips, beispielsweise einer Leistungsabnahme aufgrund Alterungseffekte, entgegengetreten werden, sodass ein über die Lebensdauer leistungsstabiler Halbleiterchip realisiert werden kann. Durch Diffusion im Spiegel kann so das Alterungsverhalten des Halbleiterchips ausgeglichen werden.

Es ist zwischen dem ersten Bereich und dem zweiten Bereich des Spiegels eine Diffusionsbarriere angeordnet. Es weist der Spiegel drei Komponenten auf, einen ersten Bereich, der überwiegend Silber enthält, einen zweiten Bereich, der überwiegend Gold enthält und dazwischen angeordnet eine Diffusionsbarriere.

In einer Abwandlung verringert die Diffusionsbarriere eine Diffusion von Spiegelmaterial zwischen dem ersten Bereich und dem zweiten Bereich. Insbesondere verringert die Diffusionsbarriere eine Diffusion von Silber in den Goldspiegel. Die Diffusionsgeschwindigkeit durch die Diffusionsbarriere ist dabei abgestimmt auf die gewünschte Änderung der Reflektivität des Spiegels im Betrieb des Halbleiterchips über dessen Lebensdauer. Dadurch kann der Verlauf der Kompensation des Leistungsverlusts basierend auf den auftretenden Alterungseffekten durch den Barrieregrad der Diffusionsbarriere eingestellt werden.

Es verhindert die Diffusionsbarriere eine Diffusion von Spiegelmaterial zwischen dem ersten Bereich und dem zweiten Bereich, wobei die Diffusionsbarriere Durchbrüche aufweist. Insbesondere verhindert die Diffusionsbarriere vollständig eine Diffusion von Silber in den Goldspiegel.

In einer Weiterbildung sind die Größe und die Verteilung der Durchbrüche der Diffusionsbarriere derart ausgebildet, dass das Diffusionsverhalten der Diffusionsbarriere einstellbar ist. Dabei wird das Diffusionsverhalten derart eingestellt, dass im Betrieb über die Lebensdauer des Halbleiterchips eine gewünschte Änderung der Reflektivität des Spiegels erzielt wird, sodass beispielsweise die auftretenden Alterungseffekte des Halbleiterchips kompensiert werden können und sich so ein leistungsstabiler Chip ermöglicht.

Unter Durchbrüche in der Diffusionsbarriere sind insbesondere Öffnungen in der Schicht der Diffusionsbarriere zu verstehen, sodass bereichsweise ein direkter Kontakt des Materials des ersten und des zweiten Bereichs in den Bereich der Öffnungen der Diffusionsbarriere ermöglicht wird.

Gemäß zumindest einer Ausführungsform des Halbleiterchips weisen die Öffnungen oder Löcher in der Diffusionsbarriere einen Durchmesser von mindestens 10 nm oder mindestens 1 µm auf. Alternativ oder zusätzlich beträgt der Durchmesser höchstens 1 µm oder höchstens 50 µm.

Gemäß zumindest einer Ausführungsform beträgt ein Anteil der Löcher oder Öffnungen in der Schicht der Diffusionsbarriere mindestens 5 % und/oder höchstens 30 %. Mit anderen Worten bedeckt dann die Schicht einen Flächenanteil des Spiegels, in Draufsicht gesehen, von mindestens 70 % und/oder von höchstens 95 %. Die Öffnungen in der Schicht können regelmäßig angeordnet oder zufällig verteilt sein. Zum Beispiel sind die Öffnungen durch ein insbesondere photolithographisch basiertes Ätzverfahren oder durch eine Stempeltechnik erzeugt.

Gemäß zumindest einer Ausführungsform des Halbleiterchips ist die Schicht der Diffusionsbarriere mit einem oder mehreren der folgenden Materialien geformt oder besteht aus einem oder mehreren der genannten Materialien: TiWN, ZnO, einem Siliziumnitrid, einem Siliziumoxid, einem Metall wie Pt. Gemäß zumindest einer Ausführungsform beträgt die Dicke der Schicht der Diffusionsbarriere mindestens 15 nm oder mindestens 30 nm und/oder höchstens 50 nm oder höchstens 100 nm. Ist die Schicht eine durchgehende Schicht ohne Öffnungen, so dass eine Diffusion von Silber in den zweiten Bereich mit Gold durch ein Material der Schicht hindurch erfolgt, so beträgt die Dicke bevorzugt zwischen einschließlich 0,1 nm und 100 nm oder zwischen einschließlich 0,5 nm und 15 nm. Das Material der Schicht ist oder umfasst dann zum Beispiel Pt oder Ti, Ni, Pd.

In einer Weiterbildung ist einer der Bereiche des Spiegels strukturiert ausgebildet. Aufgrund der Strukturierung kann das Diffusionsverhalten derart eingestellt sein, dass im Betrieb über die Lebensdauer des Halbleiterchips eine gewünschte Änderung der Reflektivität des Spiegels erzielt wird, sodass mit Vorteil ein leistungsstabiler Chip erzeugt werden kann.

Alternativ oder zusätzlich kann mittels der lateralen Ausdehnung der einzelnen Bereiche des Spiegels ein analoger Effekt erzielt werden. Beispielsweise weist der erste Bereich eine größere laterale Ausdehnung auf als der zweite Bereich, oder umgekehrt. Die laterale Ausdehnung der einzelnen Bereiche ist dabei auf die jeweilige gewünschte Änderung der Reflektivität, insbesondere Erhöhung oder Erniedrigung, und der damit verbundenen Effizienzänderung, insbesondere Steigerung oder Minderung, über die Lebensdauer des Chips abgestimmt.

In einer Weiterbildung ist der Halbleiterchip eine Dünnfilm-LED. Als Dünnfilm-LED wird im Rahmen der Anmeldung eine LED angesehen, während dessen Herstellung das Aufwachssubstrat, auf dem der Halbleiterschichtenstapel beispielsweise epitaktisch aufgewachsen wurde, vollständig oder teilweise abgelöst worden ist.

In einer Weiterbildung weist der Spiegel eine Reflektivität von weniger als 90 % auf, wobei sich mit Vorteil die Reflektivität im Betrieb des Halbleiterchips über die Lebensdauer des Halbleiterchips erhöht.

Gemäß zumindest einer Ausführungsform weist der erste Bereich, der aus Silber oder einer Silberlegierung besteht, eine Dicke von mindestens 50 nm oder von mindestens 30 nm auf. Weiterhin kann die Dicke des ersten Bereichs höchstens 500 nm oder höchstens 100 nm betragen.

Gemäß zumindest einer Ausführungsform weist der zweite Bereich, der aus Gold oder einer Goldlegierung besteht, eine Dicke von mindestens 10 nm oder von mindestens 50 nm auf. Alternativ oder zusätzlich beträgt die Dicke höchstens 200 nm oder höchstens 1 µm.

In mindestens einer Ausführungsform stehen der erste Bereich und der zweite Bereich stellenweise oder über eine gesamte Hauptfläche der Bereiche hinweg in unmittelbarem, physischem Kontakt zueinander. Mit anderen Worten berührt dann das Silber des ersten Bereichs das Gold des zweiten Bereichs mindestens an manchen Stellen.

In einem Verfahren zum Herstellen eines optoelektronischen Halbleiterchips, der einen Träger, einen Halbleiterschichtenstapel und einen Spiegel aufweist, finden folgende Verfahrensschritte Anwendung:
- Bereitstellen des Trägers,
- Aufbringen des Spiegels auf den Träger, wobei der Spiegel einen ersten Bereich aus Silber und einen zweiten Bereich aus Gold aufweist, und
- Aufbringen des Halbleiterschichtenstapels auf dem zweiten Bereich des Spiegels.

Vorteilhafte Weiterbildungen des Verfahrens ergeben sich analog zu den vorteilhaften Weiterbildungen des Halbleiterchips und umgekehrt.

In einer Weiterbildung wird die Reflektivität des Spiegels im Betrieb des Halbleiterchips über dessen Lebensdauer durch Diffusion von Silber aus dem ersten Bereich in den zweiten Bereich geändert, beispielsweise erhöht. So steigert sich beispielsweise die Reflektivität des Spiegels im Betrieb, womit die alterungsbedingte Abnahme der Leistung des Halbleiterchips kompensiert werden kann, sodass ein leistungsstabiler Halbleiterchip ermöglicht wird.

In einer Weiterbildung werden die Schichtdicken des ersten Bereichs und des zweiten Bereichs derart ausgebildet, dass das Diffusionsverhalten von Silber im Betrieb des Halbleiterchips eingestellt wird. Die Schichtdicken des Silberspiegels und des Goldspiegels sind dabei aufeinander abgestimmt. Insbesondere sind die Schichtdicken derart aufeinander abgestimmt, dass dadurch bedingt das Diffusionsverhalten von Silber im Betrieb des Halbleiterchips derart eingestellt werden kann, dass eine gewünschte Änderung der Reflektivität des Spiegels über die Lebensdauer des Halbleiterchips erfolgt.

In einer Weiterbildung ändert sich die Reflektivität des Spiegels über die Lebensdauer derart, dass sich die Leistung des Halbleiterchips um weniger als 2 % über die Lebensdauer ändert. Beispielsweise werden die Alterungseffekte, insbesondere der Verlust der Leistung des Halbleiterchips über die Lebensdauer, durch die Erhöhung der Reflektivität des Spiegels über die Lebensdauer des Halbleiterchips kompensiert, sodass ein leistungsstabiler Halbleiterchip ermöglicht wird, der eine Abweichung der Leistung von weniger als 2 % aufweist.

In einer Weiterbildung wird vor Ausbilden des Spiegels der Verlauf der Alterung des Halbleiterchips bestimmt, wobei der erste Bereich und der zweite Bereich des Spiegels derart ausgebildet werden, dass durch Änderung der Reflektivität des Spiegels über die Lebensdauer des Halbleiterchips der ermittelte Leistungsverlauf ausgeglichen wird.

Unter ausgeglichen werden ist insbesondere zu verstehen, dass sich die Leistung über die Lebensdauer des Halbleiterchips im Wesentlichen beziehungsweise nahezu nicht ändert, also auftretende Abweichungen in der Leistung über die Lebensdauer gering sind, beispielsweise unter 2% betragen.

Vorteilhafterweise wird zuerst der Verlauf des normalen Leistungsverhalten des Halbleiterchips bestimmt, und dann der Spiegel, insbesondere der erste und der zweite Bereich, so ausgebildet, dass die ermittelte Leistung des Chips über die Lebensdauer stabil bleibt. Beispielsweise kann aufgrund des Spiegels mit Vorteil einer Leistungsabnahme des Chips über die Lebensdauer entgegengetreten werden.

Es wird zwischen dem ersten Bereich und dem zweiten Bereich des Spiegels eine Diffusionsbarriere angeordnet, wobei die Diffusionsbarriere Durchbrüche aufweist, mittels deren Größe und Verteilung das Diffusionsverhalten im Betrieb des Halbleiterchips eingestellt wird.

Die Diffusionsbarriere wird somit an einzelnen Stellen beziehungsweise bereichsweise geöffnet, um ein Durchmischen des Materials des ersten und des zweiten Bereichs in diesen Bereichen zu ermöglichen. Die Geschwindigkeit der Diffusion in den Öffnungen wird über die Größe und Verteilung der Öffnungen bestimmt. Beispielsweise wird so die Erhöhung der Reflektivität des Spiegels und dadurch bedingt der Verlauf der Kompensation des Leistungsverlusts eingestellt.

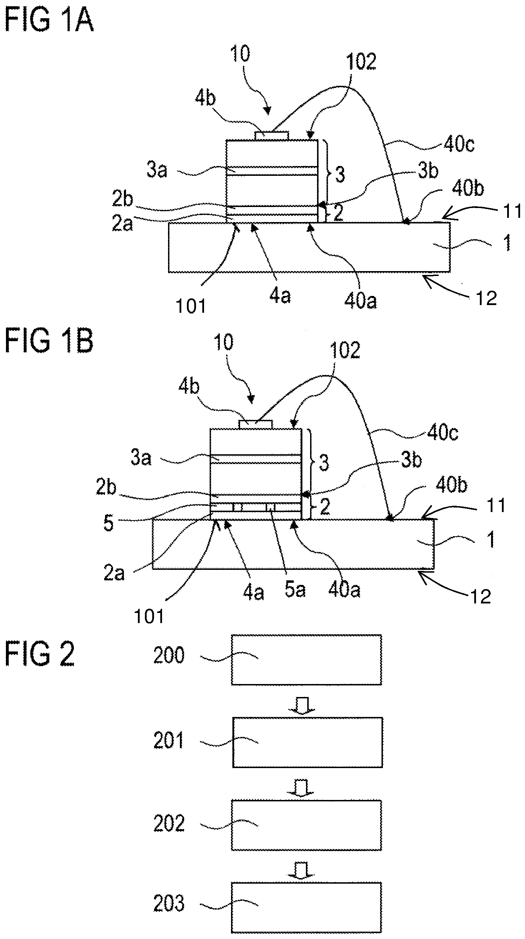

Weitere Merkmale, Vorteile, Weiterbildungen und Zweckmäßigkeiten des Halbleiterchips und dessen Verfahren ergeben sich aus den im Folgenden in Verbindung mit den Figuren 1 und 2 erläuterten Ausführungsbeispielen. Es zeigen:
- Figur 1A: einen schematischen Querschnitt einer Abwandlung eines Halbleiterchips,
- Figur 1B: einen schematischen Querschnitt eines Ausführungsbeispiels eines erfindungsgemäßen Halbleiterchips, und
- Figur 2: ein Flussdiagramm zum Herstellungsverfahren eines Ausführungsbeispiels eines erfindungsgemäßen Halbleiterchips.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

Figur 1A zeigt eine Abwandlung eines Halbleiterchips 10, der auf einer Leiterplatte 1 angeordnet ist. Zwischen Halbleiterchip 10 und Leiterplatte kann ein Träger angeordnet sein (nicht dargestellt). Der Halbleiterchip 10 ist ein optoelektronischer Halbleiterchip, insbesondere ein strahlungsemittierender Halbleiterchip. Insbesondere ist der Halbleiterchip 10 eine Dünnfilm-LED.

Die Leiterplatte 1 weist eine Oberseite 11 und eine Unterseite 12 auf. Auf der Oberseite 11 ist ein Halbleiterschichtenstapel 3 des Halbleiterchips 10 angeordnet. Mit der Unterseite 12 kann die Leiterplatte mit darauf aufgebrachtem Halbleiterchip 10 extern befestigt werden (nicht dargestellt).

Auf der Oberseite 11 sind elektrisch leitfähige Leiterbahnen 40a, 40b angeordnet. Die elektrischen Leiterbahnen 40a, 40b sind voneinander elektrisch isoliert angeordnet. Beispielsweise erfolgt die elektrische Isolierung mittels eines Abstandes oder einer elektrisch isolierenden Schicht. Die elektrischen Leiterbahnen 40a, 40b dienen zur elektrischen Kontaktierung des Halbleiterchips 10.

Der Halbleiterschichtenstapel 3 ist mit einer Befestigungsseite 101 auf einer der elektrischen Leiterbahnen 40a angeordnet und mit dieser beispielsweise über einen elektrischen Kontakt 4a elektrisch leitend verbunden. Beispielsweise ist der Halbleiterschichtenstapel 3 mit einer elektrisch leitfähigen Anschlussschicht, beispielsweise einer Klebeschicht oder einer Lötschicht, auf der Leiterbahn 40a befestigt.

Der Halbleiterschichtenstapel 3 weist auf einer Strahlungsaustrittsseite 102, die der Befestigungsseite 101 gegenüberliegt, einen weiteren elektrischen Kontakt 4b auf. Der weitere elektrische Kontakt 4b ist mit einer weiteren Leiterbahn 40b der Leiterplatte 1 mittels beispielsweise eines Bonddrahtes 40c elektrisch leitend verbunden.

Der Halbleiterschichtenstapel 3 weist demnach eine zweiseitige Kontaktierung auf. Alternativ kann der Halbleiterschichtenstapel 3 eine einseitige Kontaktierung aufweisen, wie sie beispielsweise bei Flip-Chips ausgebildet ist (nicht dargestellt). Einseitige Kontaktierungen können beispielsweise mittels zweier Bonddrähte oder mittels zweier elektrisch leitenden Klebeschichten realisiert werden. Derartige Chips sind dem Fachmann jedoch bekannt und werden daher an dieser Stelle nicht näher erläutert.

Der Halbleiterchip 10 ist ein Dünnfilmhalbleiterchip. Insbesondere ist das Aufwachssubstrat, auf dem der Halbleiterschichtenstapel 3 abgeschieden worden ist, vollständig abgelöst.

Der Halbleiterschichtenstapel 3 weist eine aktive Schicht 3a zur Erzeugung elektromagnetischer Strahlung auf. Die in der aktiven Schicht 3a erzeugte elektromagnetische Strahlung wird überwiegend an der Strahlungsaustrittsseite 102 des Halbleiterchips 10 aus dem Halbleiterchip 10 ausgekoppelt. In diesem Fall ist der weitere elektrische Kontakt 4b des Halbleiterchips 10 bevorzugt für die von der aktiven Schicht erzeugten elektromagnetischen Strahlung transparent ausgebildet, beispielsweise weist der weitere elektrische Kontakt 4b TCO oder ITO auf.

Der Halbleiterchip ist vorzugsweise ein
oberflächenemittierender Halbleiterchip.

Der Halbleiterschichtenstapel 3, insbesondere die aktive Schicht 3a, weist ein III/V-Halbleitermaterial auf. Vorzugsweise weist der Halbleiterschichtenstapel InₓGa_{y}Al_{1-x-y}P auf. Bevorzugt emittiert der Halbleiterchip 1 Strahlung im roten Wellenlängenbereich.

Zwischen dem Halbleiterschichtenstapel 3 und der Leiterplatte 1 ist ein Spiegel 2 angeordnet. Der Spiegel 2 weist einen ersten Bereich 2a und einen zweiten Bereich 2b auf. Der erste Bereich 2a enthält Silber (Ag). Der zweite Bereich 2b enthält Gold (Au). Insbesondere enthält der erste Bereich überwiegend Silber und der zweite Bereich überwiegend Gold. Der zweite Bereich 2b weist zum Beispiel eine Dicke zwischen einschließlich 10 nm und 200 nm oder zwischen einschließlich 50 nm und 200 nm auf und der erste Bereich insbesondere ein Dicke zwischen einschließlich 50 nm und 100 nm.

Der erste Bereich 2a und der zweite Bereich 2b sind vertikal übereinander angeordnet. Der erste Bereich 2a und der zweite Bereich 2b bilden somit einen Schichtstapel aus, der senkrecht zur lateralen Ausdehnung der Leiterplatte 1 ausgebildet ist. Im vorliegenden Ausführungsbeispiel ist der zweite Bereich 2b direkt unterhalb des Halbleiterschichtenstapels 3 angeordnet, wobei der zweite Bereich 2b mit dem ersten Bereich 2a hinterlegt ist, also der erste Bereich 2a auf der von dem Halbleiterschichtenstapel 3 gegenüberliegenden Seite des zweiten Bereichs 2b angeordnet ist. Eine umgekehrte Anordnung der Bereiche 2a, 2b des Spiegels ist alternativ denkbar, wobei dadurch ein umgekehrter technischer Effekt erzielt werden kann.

Es diffundiert im Betrieb des Halbleiterchips 10 Silber aus dem ersten Bereich 2a des Spiegels 2 in den zweiten Bereich 2b des Spiegels. Dadurch erhöht sich mit Vorteil über die Lebensdauer des Halbleiterchips die Reflektivität des Spiegels 2. Durch die Erhöhung der Reflektivität über die Lebensdauer kann ein auftretendes Alterungsverhalten, was sich insbesondere in einer Leistungsabnahme des Halbleiterchips über die Lebensdauer widerspiegelt, kompensiert werden. Durch die Kompensation kann so die emittierte Leistung des Halbleiterchips 10 über dessen Lebensdauer konstant oder nahezu konstant gehalten werden. Dadurch kann ein Halbleiterchip 10 erzielt werden, der über die Lebensdauer leistungsstabil ist.

Der erste Bereich 2a und der zweite Bereich 2b weisen unterschiedliche Schichtdicken auf. Insbesondere sind die Schichtdicken des ersten Bereichs 2a und des zweiten Bereichs 2b derart aufeinander abgestimmt, dass eine Diffusion von Silber aus dem ersten Bereich 2a in den zweiten Bereich 2b im Betrieb des Halbleiterchips 10 einstellbar ist.

Mittels des Diffusionsverhaltens des Silbers von dem ersten Bereich 2a in den zweiten Bereich 2b wird die Reflektivität des Spiegels 2 beeinflusst, insbesondere erhöht. Die Reflektivität des Spiegels 2 bestimmt sich somit durch das Diffusionsverhaltens des Silbers im Betrieb des Halbleiterchips 10. Mittels der Schichtdicken des ersten Bereichs 2a und des zweiten Bereichs 2b kann die Diffusionsstärke des Silbers eingestellt werden, wobei das Diffusionsverhalten wiederum Einfluss nimmt auf die Reflektivität des Spiegels 2. Abhängig von dem Alterungsverhalten des Halbleiterchips 10, insbesondere abhängig von der Leistungsabnahme über die Lebensdauer, kann so über die Schichtdicke des ersten Bereichs 2a und des zweiten Bereichs 2b das Diffusionsverhalten und somit die Reflektivität derart eingestellt werden, dass die alterungsbedingte Leistungsabnahme des Halbleiterchips 10 ausgeglichen wird.

Halbleiterchips 10, die einen derart ausgebildeten Spiegel 2 aufweisen, weisen eine Leistungsstabilität über die Lebensdauer auf. Insbesondere liegt die Änderung der Leistung über die Lebensdauer eines derartig ausgebildeten Halbleiterchips 10 bei unter 2 %, wodurch alterungsstabile Halbleiterchips, insbesondere eine alterungsstabile Strahlungsemission derartiger Halbleiterchips erzielt werden kann.

Das Ausführungsbeispiel der Figur 1B unterscheidet sich von der Abwandlung der Figur 1A dadurch, dass zwischen dem ersten Bereich 2a und dem zweiten Bereich 2b eine Diffusionsbarriere 5 angeordnet ist. Die Diffusionsbarriere 5 ist insbesondere als Schicht ausgebildet. Diese Schicht weist die Eigenschaft auf, Silbermigration vom ersten Bereich 2a in den zweiten Bereich 2b zu verlangsamen oder vollständig zu verhindern.

Ist die Diffusionsbarriere derart ausgebildet, dass eine Diffusion des Silbers vollständig verhindert wird, weist die Diffusionsbarriere Durchbrüche oder Öffnungen auf. Im Bereich der Öffnungen kann so eine Diffusion des Silbers aus dem ersten Bereich 2a in den zweiten Bereich 2b stattfinden. Die Öffnungen weisen bevorzugt Durchmesser zwischen einschließlich 10 nm und 1 µm oder zwischen einschließlich 1 µm oder 50 µm auf.

Durch die Größe und die Verteilung der Durchbrüche in der Diffusionsbarriere kann die Diffusionsgeschwindigkeit eingestellt werden. Je größer die Durchbrüche und je mehr Durchbrüche in der Diffusionsbarriere angeordnet sind, umso stärker ist das Diffusionsverhalten des Silbers aus dem ersten Bereich in den zweiten Bereich. Über die Diffusionsgeschwindigkeit kann der Kompensationsverlauf des Leistungsverlustes, wie er aufgrund des Alterungsverhaltens auftritt, bestimmt werden. Insbesondere kann durch die Diffusionsgeschwindigkeit die Erhöhung der Reflektivität des Spiegels während des Betriebs eingestellt werden, womit der alterungsbedingte Leistungsabfall des Halbleiterchips 10 kompensiert werden kann. Ein leistungsstabiler Halbleiterchip 10 kann so ermöglicht werden.

Alternativ kann einer der Bereiche 2a, 2b des Spiegels strukturiert ausgebildet sein oder eine von dem anderen Bereich unterschiedliche laterale Ausdehnung aufweisen (nicht dargestellt). Dadurch kann ein analoger Effekt wie mit der Diffusionsbarriere, insbesondere den integrierten Durchbrüchen, erzielt werden.

Im Übrigen stimmt das Ausführungsbeispiel der Figur 1B mit der Abwandlung der Figur 1A überein.

In Figur 2 ist ein Flussdiagramm eines Herstellungsverfahrens eines Halbleiterchips, wie er beispielsweise in Figur 1B ausgebildet ist, dargestellt.

Im Verfahrensschritt 200 wird ein Halbleiterschichtenstapel bereitgestellt, der eine aktive Schicht aufweist, die zur Erzeugung elektromagnetischer Strahlung geeignet ist. Zudem wird im Verfahrensschritt 200 das Alterungsverhalten des Halbleiterschichtenstapels ermittelt. Insbesondere wird der Verlauf der normalen Alterung des Halbleiterchips bestimmt.

In Verfahrensschritt 201 wird ein Träger bereitgestellt, auf dem ein Spiegel aufgebracht wird. Der Spiegel setzt sich insbesondere durch einen ersten Bereich und einen zweiten Bereich zusammen. Der erste Bereich ist ein Silberspiegel und der zweite Bereich ist ein Goldspiegel. Die Schichtdicke der Spiegel sind abhängig von dem zuvor bestimmten Alterungsverhalten des Halbleiterchips 10 ausgebildet. Insbesondere sind die Schichtdicken des Silberspiegels und des Goldspiegels derart aufeinander abgestimmt, dass die Diffusionsstärke im Betreib des Halbleiterchips auf das Alterungsverhalten des Halbleiterchips angepasst ist. Durch Diffusion des Silbers aus dem Silberspiegel in den Goldspiegel kann sich über die Lebensdauer des Halbleiterchips die Reflektivität des Spiegels verändern, wodurch die alterungsbedingte Leistungsabnahme ausgeglichen werden kann. Die Dicken der Bereiche des Spiegels sind dabei derart ausgebildet, dass eine möglichst geringe Abweichung der Leistung über die Lebensdauer auftritt, wobei insbesondere die Abweichung der Leistung weniger als 2 % über die Lebensdauer beträgt.

Es wird zwischen dem ersten Bereich und dem zweiten Bereich des Spiegels eine Diffusionsbarriere angeordnet. Diese Barriere reduziert, verlangsamt oder verhindert die Durchmischung des Silbers in dem Goldspiegel. Es werden in der Diffusionsbarriere Durchbrüche ausgebildet, um in diesen Bereichen eine Diffusion des Silbers aus dem ersten Bereich in den zweiten Bereich des Spiegels zu ermöglichen. Über die Größe und Verteilung der Durchbrüche kann die Diffusionsgeschwindigkeit eingestellt werden, womit abhängig von dem Alterungsverhalten des Halbleiterchips die Reflektivität des Spiegels so erhöht werden kann.

Im Verfahrensschritt 202 wird der Halbleiterschichtenstapel auf den zweiten Bereich des Spiegels aufgebracht. Der Halbleiterschichtenstapel, insbesondere das Alterungsverhalten des Halbleiterschichtenstapels, ist optimal an den Spiegel auf dem Träger angepasst, insbesondere mittels der Schichtdicken der Bereiche des Spiegels und/oder der optionalen Diffusionsbarriere. Insbesondere kann der alterungsbedingten Leistungsabnahme über die Lebensdauer des Halbleiterchips durch die sich erhöhende Reflektivität des Spiegels über die Lebensdauer des Halbleiterchips entgegengetreten werden.

Im Verfahrensschritt 203 wird der Halbleiterchip elektrisch kontaktiert und in Betrieb genommen. Während des Betriebs des Halbleiterchips findet eine Diffusion von Silber aus dem ersten Bereich des Spiegels in den zweiten Bereich des Spiegels statt, der zu einer erhöhten Reflektivität des Spiegels 2 führt. Damit kann das Alterungsverhalten des Halbleiterchips über die Lebensdauer kompensiert werden, womit ein leistungsstabiler Halbleiterchip ermöglicht wird.

## Patentansprüche

1. Optoelektronischer Halbleiterchip (10) mit einem Halbleiterschichtenstapel (3) und einem Spiegel (2), wobei
- der Halbleiterschichtenstapel (3) eine aktive Schicht (3a) zur Erzeugung elektromagnetischer Strahlung aufweist,
- der Spiegel (2) an einer Unterseite (3b) des Halbleiterschichtenstapels (3) angeordnet ist,
- der Spiegel (2) einen ersten Bereich (2a) und einen zweiten Bereich (2b) aufweist,
- der erste Bereich (2a) Ag enthält,
- der zweite Bereich (2b) Au enthält,
- zwischen dem ersten Bereich (2a) und dem zweiten Bereich (2b) eine Diffusionsbarriere (5) angeordnet ist, und
- die Diffusionsbarriere (5) in unmittelbarem Kontakt zu dem ersten und dem zweiten Bereich (2a, 2b) steht, **dadurch gekennzeichnet, dass**
die Diffusionsbarriere (5) eine Diffusion von Spiegelmaterial zwischen dem ersten Bereich (2a) und dem zweiten Bereich (2b) verhindert und die Diffusionsbarriere (5) Durchbrüche (5a) aufweist.

2. Halbleiterchip nach Anspruch 1, wobei der erste Bereich (2a) und der zweite Bereich (2b) vertikal übereinander angeordnet sind und mindestens stellenweise in unmittelbarem Kontakt zueinander stehen.

3. Halbleiterchip nach einem der vorhergehenden Ansprüche, wobei
der erste Bereich (2a) und der zweite Bereich (2b) unterschiedliche Schichtdicken aufweisen.

4. Halbleiterchip nach Anspruch 3, wobei die Schichtdicken des ersten Bereichs (2a) und des zweiten Bereichs (2b) derart aufeinander abgestimmt sind, dass ein Diffusionsverhalten von Ag aus dem ersten Bereich (2a) in den zweiten Bereich (2b) im Betrieb des Halbleiterchips (10) einstellbar ist.

5. Halbleiterchip nach einem der vorhergehenden Ansprüche, wobei
die Größe und Verteilung der Durchbrüche (5a) derart ausgebildet sind, dass das Diffusionsverhalten der Diffusionsbarriere (5) einstellbar ist.

6. Halbleiterchip nach einem der vorhergehenden Ansprüche, wobei
der Halbleiterchip (10) eine Dünnfilm-LED ist.

7. Verfahren zum Herstellen eines optoelektronischen Halbleiterchips (10) nach einem der vorhergehenden Ansprüche, der einen Halbleiterschichtenstapel (3) und einen Spiegel (2) aufweist, mit folgenden Verfahrensschritten:
- Bereitstellen eines Trägers (1),
- Aufbringen des Spiegels (2) auf dem Träger (1), wobei der Spiegel (2) einen ersten Bereich (2a) aus Ag und einen zweiten Bereich (2b) aus Au aufweist, und
- Aufbringen des Halbleiterschichtenstapels (3) auf den zweiten Bereich (2b) des Spiegels,
wobei zwischen dem ersten Bereich (2a) und dem zweiten Bereich (2b) eine Diffusionsbarriere (5) angeordnet wird, die Durchbrüche (5a) aufweist, mittels deren Größe und Verteilung das Diffusionsverhalten im Betrieb des Halbleiterchips (10) eingestellt wird.

8. Verfahren nach Anspruch 7, wobei
sich die Reflektivität des Spiegels (2) über die Lebensdauer des Halbleiterchips (10) derart ändert, dass sich die Leistung des Halbleiterchips (10) um weniger als 2% über die Lebensdauer ändert.

9. Verfahren nach Anspruch 7 oder 8, wobei sich die Reflektivität des Spiegels (2) über die Lebensdauer des Halbleiterchips (10) durch Diffusion von Ag aus dem ersten Bereich (2a) in den zweiten Bereich (2b) erhöht.

10. Verfahren nach einem der Ansprüche 7 bis 9, wobei die Schichtdicken des ersten Bereichs (2a) und des zweiten Bereichs (2b) derart ausgebildet werden, dass das Diffusionsverhalten von Ag im Betrieb des Halbleiterchips (10) eingestellt wird.

11. Verfahren nach einem der vorhergehenden Ansprüche 7 bis 10, wobei
- vor Ausbilden des Spiegels (2) der Verlauf der Alterung des Halbleiterchips (10) bestimmt wird, und
- der erste Bereich (2a) und der zweite Bereich (2b) des Spiegels (2) derart ausgebildet werden, dass durch Erhöhung der Reflektivität des Spiegels (2) über die Lebensdauer des Halbleiterchips (10) das Alterungsverhalten ausgeglichen wird.

## Claims

1. Optoelectronic semiconductor chip (10) comprising a semiconductor layer stack (3) and a mirror (2), wherein
- the semiconductor layer stack (3) has an active layer (3a) for generating electromagnetic radiation,
- the mirror (2) is arranged at an underside (3b) of the semiconductor layer stack (3),
- the mirror (2) has a first region (2a) and a second region (2b),
- the first region (2a) contains Ag,
- the second region (2b) contains Au,
- a diffusion barrier (5) is arranged between the first region (2a) and the second region (2b), and
- the diffusion barrier (5) is in direct contact with the first and second regions (2a, 2b),
**characterized in that**
the diffusion barrier (5) prevents a diffusion of mirror material between the first region (2a) and the second region (2b), and the diffusion barrier (5) has perforations (5a).

2. Semiconductor chip according to Claim 1, wherein the first region (2a) and the second region (2b) are arranged vertically one above the other and are in direct contact with one another at least in places.

3. Semiconductor chip according to either of the preceding claims, wherein
the first region (2a) and the second region (2b) have different layer thicknesses.

4. Semiconductor chip according to Claim 3, wherein
the layer thicknesses of the first region (2a) and of the second region (2b) are coordinated with one another in such a way that a diffusion behaviour of Ag from the first region (2a) into the second region (2b) during operation of the semiconductor chip (10) is settable.

5. Semiconductor chip according to any of the preceding claims, wherein
the size and distribution of the perforations (5a) are embodied in such a way that the diffusion behaviour of the diffusion barrier (5) is settable.

6. Semiconductor chip according to any of the preceding claims, wherein
the semiconductor chip (10) is a thin-film LED.

7. Method for producing a optoelectronic semiconductor chip (10) according to any of the preceding claims, which semiconductor chip has a semiconductor layer stack (3) and a mirror (2), comprising the following method steps:
- providing a carrier (1),
- applying the mirror (2) on the carrier (1), wherein the mirror (2) has a first region (2a) composed of Ag and a second region (2b) composed of Au, and
- applying the semiconductor layer stack (3) to the second region (2b) of the mirror,
wherein a diffusion barrier (5) is arranged between the first region (2a) and the second region (2b), said diffusion barrier having perforations (5a), by means of whose size and distribution the diffusion behaviour during operation of the semiconductor chip (10) is set.

8. Method according to Claim 7, wherein
the reflectivity of the mirror (2) changes over the lifetime of the semiconductor chip (10) in such a way that the power of the semiconductor chip (10) changes by less than 2% over the lifetime.

9. Method according to Claim 7 or 8, wherein
the reflectivity of the mirror (2) increases over the lifetime of the semiconductor chip (10) by the diffusion of Ag from the first region (2a) into the second region (2b).

10. Method according to any of Claims 7 to 9, wherein
the layer thicknesses of the first region (2a) and of the second region (2b) are embodied in such a way that the diffusion behaviour of Ag during operation of the semiconductor chip (10) is set.

11. Method according to any of the preceding Claims 7 to 10, wherein
- the profile of the change of the semiconductor chip (10) is determined before the mirror (2) is formed, and
- the first region (2a) and the second region (2b) of the mirror (2) are embodied in such a way that ageing behaviour is compensated for by increasing the reflectivity of the mirror (2) over the lifetime of the semiconductor chip (10).

## Revendications

1. Puce à semi-conducteur optoélectronique (10) comportant un empilement de couches de semi-conducteur (3) et un miroir (2), dans laquelle
- l'empilement de couches de semi-conducteur (3) comporte une couche active (3a) destinée à générer un rayonnement électromagnétique,
- le miroir (2) est disposé sur une face inférieure (3b) de l'empilement de couches de semi-conducteur (3),
- le miroir (2) comporte une première région (2a) et une deuxième région (2b),
- la première région (2a) Contient de l'Ag,
- la deuxième région (2b) Contient de l'Au,
- une barrière de diffusion (5) est disposée entre la première région (2a) et la deuxième région (2b), et
- la barrière de diffusion (5) est en contact direct avec les première et deuxième régions (2a, 2b), **caractérisée en ce que** la barrière de diffusion (5) empêche une diffusion de matériau du miroir entre la première région (2a) et la deuxième région (2b) et **en ce que** la barrière de diffusion (5) comporte des perforations (5a).

2. Puce à semi-conducteur selon la revendication 1, dans laquelle
la première région (2a) et la deuxième région (2b) sont disposées verticalement les unes sur les autres et sont au moins par endroits en contact direct les unes avec les autres.

3. Puce à semi-conducteur selon l'une quelconque des revendications précédentes, dans laquelle
la première région (2a) et la deuxième région (2b) présentent des épaisseurs de couches différentes.

4. Puce à semi-conducteur selon la revendication 3, dans laquelle
les épaisseurs de couches de la première région (2a) et de la deuxième région (2b) sont adaptées les unes aux autres de manière à pouvoir régler un comportement en diffusion de l'Ag de la première région (2a) vers la deuxième région (2b) lors du fonctionnement de la puce à semi-conducteur (10).

5. Puce à semi-conducteur selon l'une quelconque des revendications précédentes, dans laquelle
la taille et la distribution des perforations (5a) sont établies de manière à pouvoir régler le comportement en diffusion de la barrière de diffusion (5).

6. Puce à semi-conducteur selon l'une quelconque des revendications précédentes, dans laquelle la puce à semi-conducteur (10) est une LED à couche mince.

7. Procédé de fabrication d'une puce optoélectronique à semi-conducteur (10) selon l'une quelconque des revendications précédentes, qui comporte un empilement de couches de semi-conducteur (3) et un miroir (2), comprenant les étapes de procédé suivantes :
- fournir un support (1),
- appliquer le miroir (2) sur le support (1),
dans lequel le miroir (2) comporte une première région (2a) constituée d'Ag et une deuxième région (2b) constituée d'Au, et
- appliquer l'empilement de couches de semi-conducteur (3) sur la deuxième région (2b) du miroir,
dans laquelle une barrière de diffusion (5) est disposée entre la première région (2a) et la deuxième région (2b), laquelle barrière de diffusion comporte des perforations (5a) dont la taille et la distribution permettent de régler le comportement en diffusion lors du fonctionnement de la puce à semi-conducteur (10).

8. Procédé selon la revendication 7, dans lequel la réflectivité du miroir (2) varie au cours de la durée de vie de la puce à semi-conducteur (10) de telle sorte que la puissance de la puce à semi-conducteur (10) varie de moins de 2% au cours de ladite durée de vie.

9. Procédé selon la revendication 7 ou 8, dans lequel
la réflectivité du miroir (2) augmente au cours de la durée de vie de la puce à semi-conducteur (10) par diffusion de l'Ag de la première région (2a) vers la deuxième région (2b).

10. Procédé selon l'une quelconque des revendications 7 à 9, dans lequel les épaisseurs de couches de la première région (2a) et de la deuxième région (2b) sont établies de manière à permettre de régler le comportement en diffusion de l'Ag lors du fonctionnement de la puce à semi-conducteur (10).

11. Procédé selon l'une quelconque des revendications précédentes 7 à 10, dans lequel
- avant de réaliser le miroir (2), l'évolution du vieillissement de la puce à semi-conducteur (10) est déterminée, et
- la première région (2a) et la deuxième région (2b) du miroir (2) sont réalisées de manière à ce que le comportement au vieillissement soit compensé par l'augmentation de la réflectivité du miroir (2) au cours de la durée de vie de la puce à semi-conducteur (10).
